# DEMANDE DE BREVET EUROPEEN

(11) **EP 1 380 473 A1**
(43) Date de publication de la demande: **14.01.2004**
(21) Numéro de dépôt: 03291623.1
(22) Date de dépôt: 01.07.2003
(51) Int. Cl.: B60R 16/02, H05K 7/02

(54) **Boîte d'interconnexion**

(30) Priorité: 09.07.2002 FR 0208634
(71) Demandeur: Valeo Electronique et Systemes de Liaison, 78180 Montigny le Bretonneux (FR)
(72) Inventeur: Thiollay, Lionel, 91260 Juvisy Sur Orge (FR); Dardelin, Régis, 92420 Vaucresson (FR)
(74) Mandataire: Faber, Jean-Paul

(57) **Abrégé**

Boîte d'interconnexion du type comprenant un corps (2) dans lequel est disposée une plaque (4) supportant des circuits électriques, des composants électroniques et des supports (6) pour des fusibles, un couvercle (3) destiné à être fixé de manière étanche sur le corps (2) et présentant une ouverture (12) dans laquelle s'étendent les supports (6) pour les fusibles (7, 8), caractérisée en ce que la partie des supports (6) adjacente à la plaque (4) est noyée dans une couche de résine (40), tandis que le couvercle comporte des lumières s'ouvrant sur la paroi latérale et inclinées en direction de celle-ci.

## Description

La présente invention se rapporte à des boîtes d'interconnexion, boîtes de calculateurs ou autres.

L'invention vise des boîtes d'interconnexion comprenant un corps dans lequel est logée une plaque dont une face supporte des circuits imprimés ou découpés et l'autre des composants électroniques, électriques et des fusibles et un couvercle.

Pour certaines applications, il est souhaitable que la boîte soit étanche, mais on doit obligatoirement avoir accès aux fusibles afin de pouvoir les changer si cela est nécessaire, de sorte que l'étanchéité est difficile à obtenir.

L'un des buts de la présente invention est de réaliser une boîte d'interconnexion qui remédie à cet inconvénient.

La boîte d'interconnexion, selon l'invention, est du type comprenant un corps dans lequel est disposée une plaque supportant des circuits électriques, des composants électroniques et des supports pour des fusibles, un couvercle destiné à être fixé de manière étanche sur le corps et présentant des logements pour des fusibles comportant des pattes destinées à coopérer avec les supports reliés à la plaque, ladite boîte étant caractérisée en ce que la partie des supports adjacente à la plaque est noyée dans une couche de résine, tandis que le couvercle comporte des lumières s'ouvrant sur une paroi latérale et inclinées en direction de celle-ci.

Suivant une autre caractéristique, le couvercle présente une ouverture dans laquelle s'étendent les supports, celle-ci étant bordée par des côtés qui s'étendent pour porter contre la face correspondante de la plaque.

Suivant un détail constructif, l'ouverture débouche sur une paroi latérale qui présente une large entaille délimitée par une nervure s'étendant dans le prolongement du bord libre de la paroi latérale correspondant du couvercle.

De préférence, la couche de résine est inclinée en direction de la nervure.

Suivant une caractéristique de détail, la boîte d'interconnexion comporte un cache destiné à être inséré dans l'ouverture et comportant les logements et les fentes alignés avec les supports pour le passage des pattes des fusibles.

Suivant un détail constructif, le cache présente une section en L avec une plaquette et une barrette, la barrette étant destinée à s'insérer dans la large entaille de la paroi latérale du couvercle, tandis que les côtés bordant l'ouverture comportent des moyens pour la fixation de la plaquette.

De préférence, les extrémités de la plaquette sont pourvues de languettes destinées à s'insérer dans des rainures des côtés correspondants de l'ouverture.

Afin de faciliter l'évacuation de l'humidité pouvant se produire dans l'ouverture, la barrette du cache présente des lumières s'ouvrant sur son bord libre.

La boîte d'interconnexion peut comporter une cosse pourvue de broches traversant la plaque et en partie noyées dans la couche de résine, la cosse traversant une lumière correspondante du cache.

Suivant une variante de réalisation, le couvercle comporte un emplacement pourvu de séries de logements destinés à recevoir les fusibles et présentant des fentes pour le passage des pattes desdits fusibles, en regard desdites fentes s'étendant les supports de la plaque, lesdits logements étant alignés par série et entre chaque série s'étendant, dans le couvercle, une rainure s'ouvrant sur une paroi latérale de celui-ci, chaque rainure présentant, en un point intermédiaire de la longueur, un trou débouchant sur la plaque tandis que la face inférieure du couvercle est pourvue d'un rebord coopérant avec la face correspondante de la plaque et circonscrivant la partie de celle-ci pourvue des supports, la résine étant déposée sur la plaque à travers les trous.

Enfin, les rainures sont inclinées en direction de leur partie s'ouvrant sur la paroi latérale.

L'invention va maintenant être décrite avec plus de détails en se référant à des modes de réalisation particuliers donnés à titre d'exemple seulement et représentés aux dessins annexés.

Figure 1 est une vue en perspective d'une boîte d'interconnexion, selon l'invention.

Figure 2 est une vue en perspective éclatée de la boîte d'interconnexion, selon l'invention.

Figure 3 montre en coupe une partie de la boîte d'interconnexion.

Figure 4 montre également en coupe une partie de la boîte d'interconnexion.

Figure 5 et figure 6 sont des vues en perspective d'une variante de réalisation.

Figure 7 est une vue en perspective d'un autre mode de réalisation de l'invention.

Figure 8 est une vue en coupe suivant la ligne 8-8 de la figure 7.

Figure 9 est une vue en coupe suivant la ligne 9-9 de la figure 7.

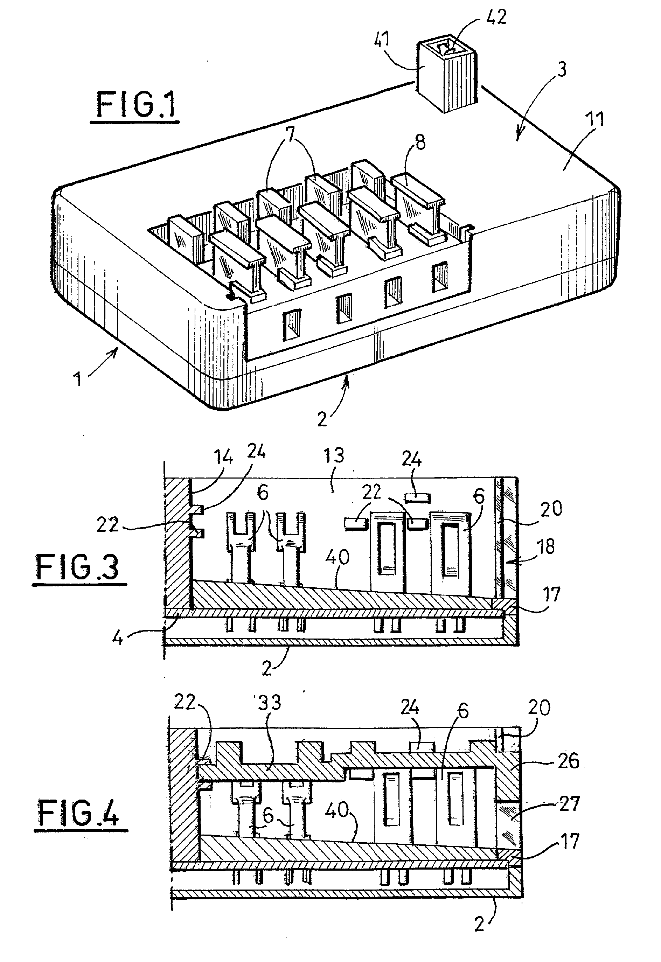

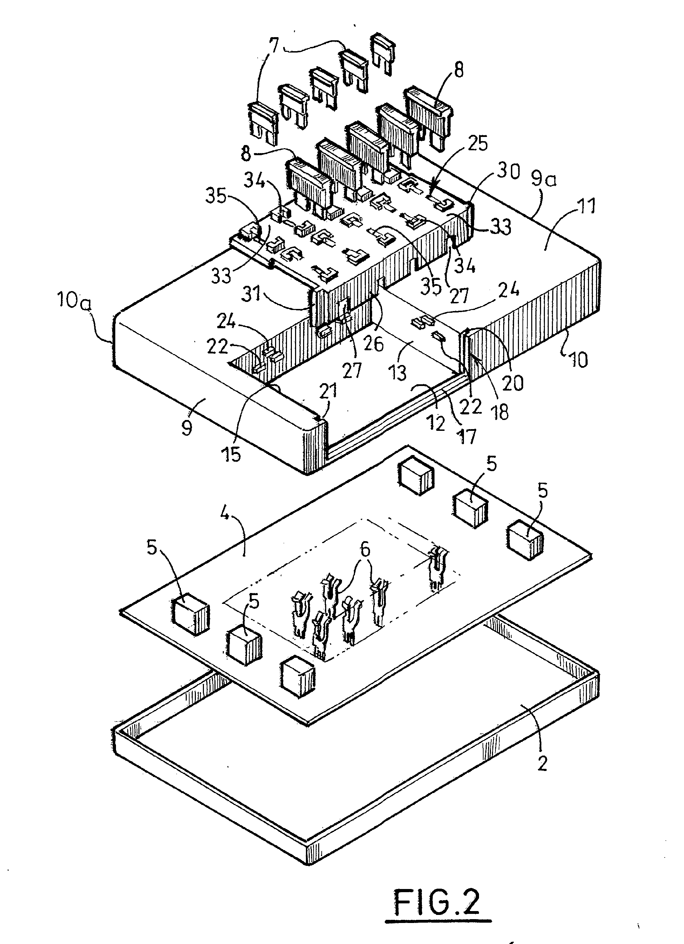

Aux figures 1 à 4, on a représenté une boîte d'interconnexion désignée dans son ensemble par la référence 1 et comprenant un corps 2 et un couvercle 3.

Dans le corps 2 est logée une plaque 4 qui supporte, sur une face tournée vers le fond du corps 2, des circuits électriques imprimés ou des circuits électriques découpés et sur l'autre face différents composants électroniques 5 reliés aux différents circuits et des supports 6 pour des fusibles 7 et 8 pourvus de broches traversant des ouvertures de la plaque 4 et insérés sur les circuits électriques.

Le couvercle 3 comporte des parois latérales 9, 9a et 10, 10a et une paroi supérieure 11 qui présente une ouverture 12 s'ouvrant sur la paroi latérale 10.

L'ouverture 12 est bordée par trois côtés 13, 14 et 15 qui s'étendent jusqu'au niveau du bord libre des parois latérales 7 à 10, tandis que la paroi latérale 10 présente une entaille 18 délimitant une nervure 17.

Les côtés 13 et 15, au voisinage de la nervure 17, sont pourvus de rainures 20, 21 respectivement.

Les côtés 13, 14 et 15 comportent des saillies 22 constituant des butées et des saillies formant des organes de retenue 24.

Il est prévu un cache 25 à section en L avec une plaquette 33 et une barrette 26 pourvue de lumières 27 et dont les extrémités libres présentent des languettes 30 et 31 destinées à s'insérer respectivement dans les rainures 20 et 21, le bord libre de la barrette 26 reposant sur la nervure 17 et les lumières 27 s'ouvrant sur celui-ci.

La plaquette 33 présente des logements 34 pour maintenir et guider les fusibles et des fentes 35 alignées dans les logements pour le passage des pattes des fusibles qui sont destinées à s'insérer dans les supports 6.

Conformément à l'invention, la plaque 4 est logée dans le corps 2, puis le couvercle 3 est fixé sur le bord du corps 2, par exemple, soudé ou collé avec une résine compatible avec une matière plastique dans laquelle ledit corps et ledit couvercle sont réalisés.

Les supports 6 s'étendent dans l'ouverture 12. De manière à assurer l'étanchéité des différents éléments insérés entre le corps 2 et le couvercle 3, on coule sur la plaque 4, dans l'ouverture 12, une résine 40 celle-ci se liant non seulement avec la plaque 4 mais également avec les côtés 13, 14 et 15 et avec la nervure 17. Les supports 6 se trouvent ainsi, dans leur partie attenante à la plaque 4, noyés dans la résine 40 de sorte que les ouvertures de la plaque 4, au travers desquelles passent les broches des supports 6, se trouvent obturées.

De préférence, la couche de résine 40 est déposée sur la plaque 4 de manière que son épaisseur, au droit de la paroi 14, soit supérieure à son épaisseur au voisinage de la nervure 17 afin de présenter une légère pente.

Lorsque la résine 40 a durci, on met en place le cache 25 en engageant les languettes 30 et 31 respectivement dans les rainures 20 et 21, la plaquette 33 venant reposer sur les saillies 22 et étant bloquée par les saillies 24.

Le couvercle 2 comporte, venu de moulage, un connecteur 41 destiné à recevoir un élément complémentaire et pourvu de broches 42 pour l'alimentation des composants 5 ou, au contraire, pour véhiculer les signaux émis par ceux-ci.

Si les parties situées dans l'ouverture 12 sont humides, cette humidité peut s'évacuer par les lumières 27, ce qui est facilité par la pente de la couche de résine 40.

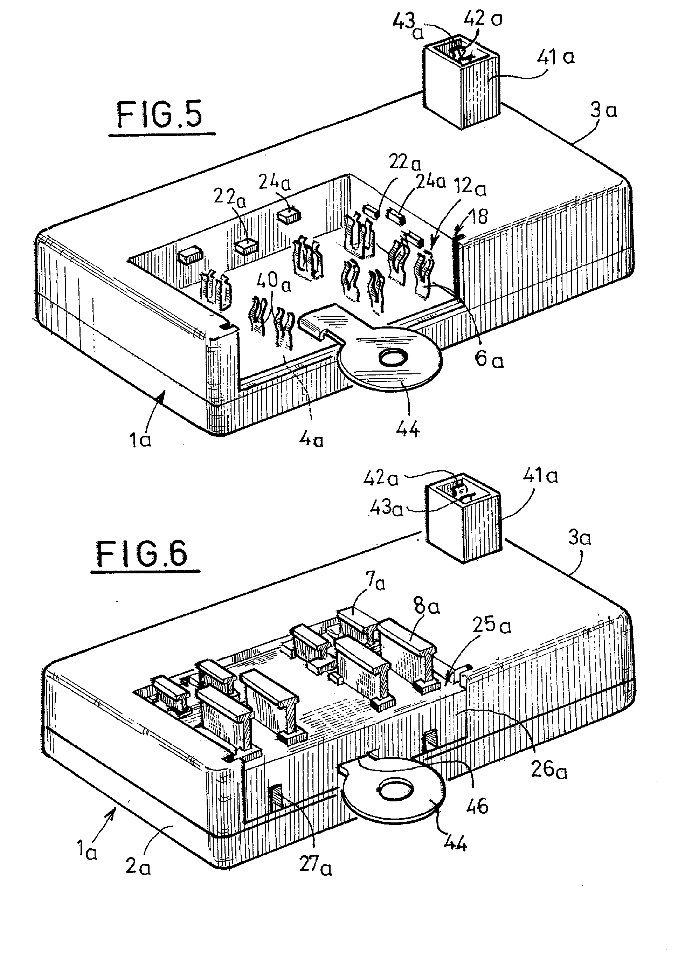

Aux figures 5 et 6, on a représenté une variante de réalisation dans laquelle la boîte d'interconnexion est réalisée de la même manière que celle des figures 1 à 4. On a porté sur les figures 5 et 6 les références utilisées pour désigner les éléments correspondants mais affectées de la lettre "a".

La boîte comporte en plus une cosse d'alimentation 44 qui présente des broches traversant la plaque 4a, broches reliées aux différents circuits, tandis que la cosse 44 est destinée à être reliée à une source de courant électrique.

De la résine 40a est déposée sur la plaque 4a dans l'ouverture 12a de sorte que la partie de la cosse adjacente à la plaque 4a ainsi que les embases des supports 6a sont noyées dans la résine.

Après la prise de la résine, le cache 25a est mis en place et en plus des lumières 27a la barrette 26a est pourvue d'une large lumière 46 pour permettre le passage de la cosse 44.

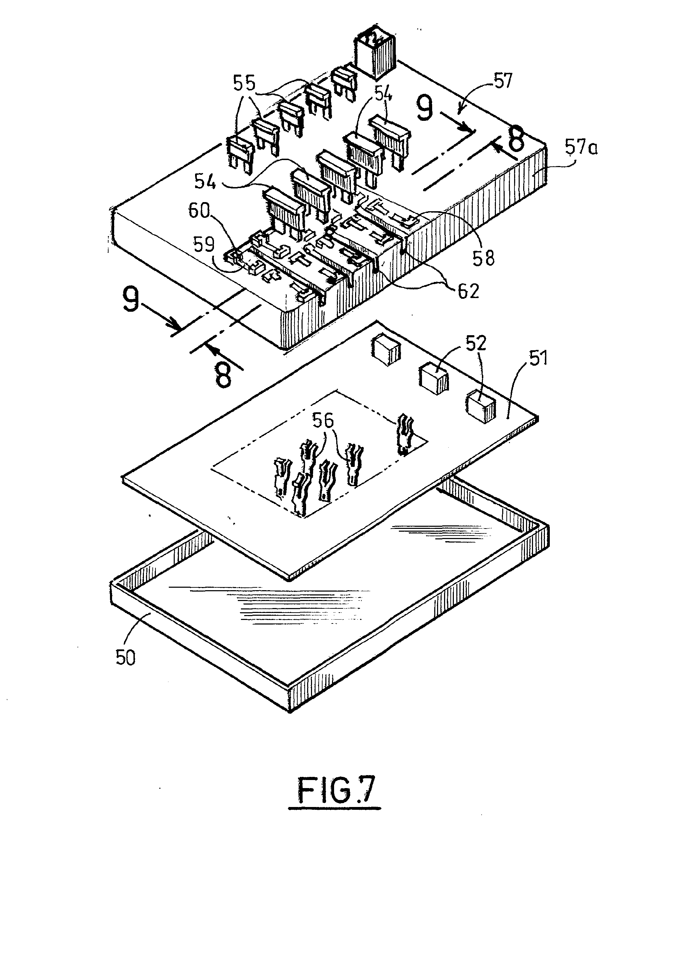

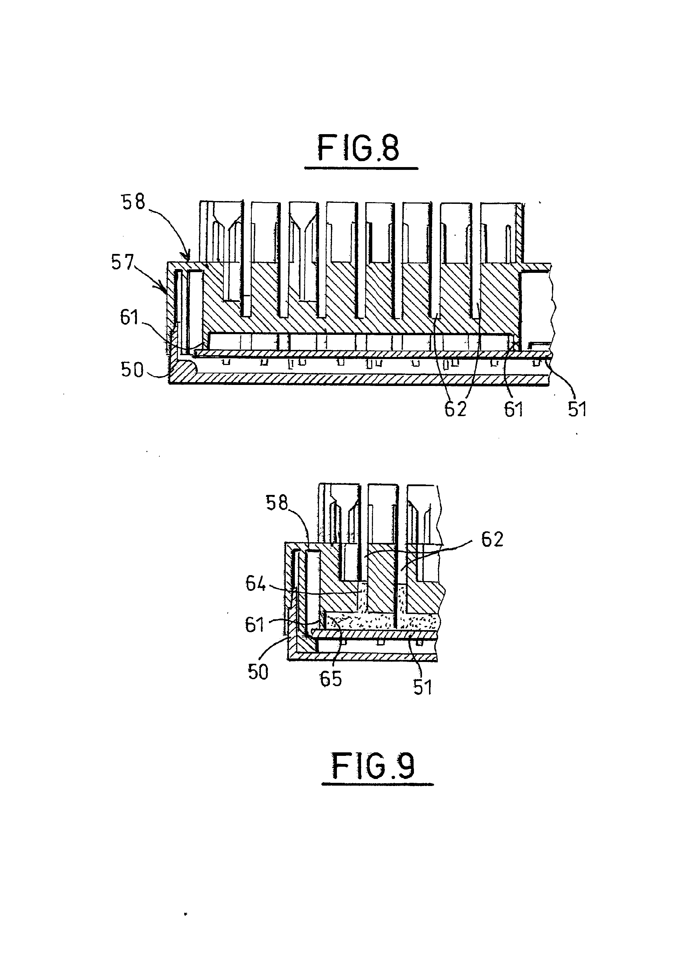

Aux figures 7 et 9, on a représenté une variante de réalisation dans laquelle la boîte d'interconnexion est légèrement différente de celle décrite aux figures 1 à 4 et 5 et 6.

La boîte est constituée d'un corps 50 dans lequel est logée une plaque 51 qui supporte, sur sa face tournée vers le fond dudit corps 50, des circuits électriques imprimés ou découpés et, sur l'autre face, différents composants électroniques reliés aux différents circuits. Sur la plaque 51 s'érigent des supports 56 pour des fusibles 54 et 55.

La boîte est fermée par un couvercle 57 qui présente un emplacement 58 pourvu de logements 60 avec des fentes 59 destinées au passage des pattes des fusibles qui s'insèrent dans les supports 56.

L'emplacement 58 est bordé, du côté interne du couvercle, par un rebord 61 destiné à porter contre la plaque 51 et sa face supérieure est pourvue d'une série de rainures 62 s'ouvrant du côté d'une face latérale 57a du couvercle.

Les rainures 62 sont pratiquées entre les lignes de logements 60 pour les fusibles et, en un point intermédiaire de leur longueur, elles comportent un trou 64 qui s'ouvre en regard de la partie de la plaque 51 pourvue des supports 56.

Lorsque le couvercle 57 est posé et fixé sur le corps 50, on coule à travers les trous 64 la résine 65 de manière que l'espace délimité par le rebord 61 soit rempli, les embases des supports 56 étant, ainsi, noyées dans la résine. De préférence, la résine est déversée de manière à remplir les trous 64 afin que les rainures 62 qui sont inclinées en direction de la paroi 57a constituent des gouttières pour l'écoulement de l'eau.

Bien entendu, l'invention n'est pas limitée aux modes de réalisation qui viennent d'être décrits et représentés. On pourra y apporter de nombreuses modifications de détail sans sortir pour cela du cadre de l'invention.

## Revendications

1. Boîte d'interconnexion du type comprenant un corps (2, 50) dans lequel est disposée une plaque (4, 51) supportant des circuits électriques, des composants électroniques et des supports (6, 56) pour des fusibles, un couvercle (3) destiné à être fixé de manière étanche sur le corps (2) et présentant des logements (35, 60) pour des fusibles (7, 8, 54, 55) comportant des pattes destinées à coopérer avec les supports (6, 56) reliés à la plaque (4, 51), **caractérisée en ce que** la partie des supports (6, 56) adjacente à la plaque (4, 51) est noyée dans une couche de résine (40, 65), tandis que le couvercle comporte des lumières s'ouvrant sur une paroi latérale et inclinées en direction de celle-ci.

2. Boîte d'interconnexion, selon la revendication 1, **caractérisée en ce que** le couvercle (3) présente une ouverture (12) dans laquelle s'étendent les supports (6), celle-ci étant bordée par des côtés (13, 14, 15) qui s'étendent pour porter contre la face correspondante de la plaque (4).

3. Boîte d'interconnexion, selon les revendications 1 et 2, **caractérisée en ce que** l'ouverture (12) débouche sur une paroi latérale (10) qui présente une large entaille (18) délimitée par une nervure (17) s'étendant dans le prolongement du bord libre de la paroi latérale correspondante du couvercle (3).

4. Boîte d'interconnexion, selon les revendications 1, 2 et 3, **caractérisée en ce que** la couche de résine (40) est inclinée en direction de la nervure (17).

5. Boîte d'interconnexion, selon la revendication 1, **caractérisée en ce qu'**elle comporte un cache (25) destiné à être inséré dans l'ouverture (12) et comportant les logements et les fentes (35) alignés avec les supports pour le passage des pattes des fusibles (7, 8).

6. Boîte d'interconnexion, selon les revendications 2, 3 et 5, **caractérisée en ce que** le cache (25) présente une section en L avec une plaquette (33) et une barrette (26), la barrette étant destinée à s'insérer dans la large entaille de la paroi latérale du couvercle (3), tandis que les côtés (13, 14, 15) bordant l'ouverture (12) comportent des moyens (22, 24) pour la fixation de la plaquette (33).

7. Boîte d'interconnexion, selon la revendication 6, **caractérisée en ce que** les extrémités de la plaquette (33) sont pourvues de languettes (30, 31) destinées à s'insérer dans des rainures des côtés (13, 15) correspondants de l'ouverture (12).

8. Boîte d'interconnexion, selon la revendication 6, **caractérisée en ce que** la barrette (26) du cache (25) présente des lumières (27) s'ouvrant sur son bord libre.

9. Boîte d'interconnexion, selon les revendications 1, 5, 6 et 8, **caractérisée en ce qu'**elle comporte une cosse (44) pourvue de broches traversant la plaque (4a) et en partie noyées dans la couche de résine (40a), la cosse traversant une lumière correspondante du cache (25a).

10. Boîte d'interconnexion, selon la revendication 1, **caractérisée en ce que** le couvercle (57) comporte un emplacements (58) pourvu de séries de fentes (59, 60) pour le passage des pattes des fusibles, en regard desdites fentes, s'étendant les supports (56) de la plaque (51), lesdits emplacements étant alignés par série et entre chaque série s'étendant dans le couvercle, une rainure (62) s'ouvrant sur une paroi latérale (57a) de celui-ci, chaque rainure (62) présentant, en un point intermédiaire de sa longueur, un trou (64) débouchant sur la plaque (51) tandis que la face inférieure du couvercle est pourvue d'un rebord (61) coopérant avec la face correspondante de la plaque et circonscrivant la partie de celle-ci pourvue des supports (56), la résine (65) étant déposée sur la plaque (51) à travers les trous (64).

11. Boîte d'interconnexion, selon la revendication 10, **caractérisée en ce que** les rainures (62) sont inclinées en direction de leur partie s'ouvrant sur la paroi latérale (57a).
